Europäisches Patentamt

European Patent Office

Office européen des brevets

(11) Numéro de publication: **0 375 051**

**A1**

## (12) DEMANDE DE BREVET EUROPEEN

(21) Numéro de dépôt: 89203219.4

(22) Date de dépôt: **18.12.89**

(51) Int. Cl.⁵: **C23C 16/44, C23C 16/50**

(30) Priorité: **22.12.88 FR 8817369**

(43) Date de publication de la demande:
**27.06.90 Bulletin 90/26**

(84) Etats contractants désignés:
**CH DE ES FR GB IT LI LU NL SE**

(71) Demandeur: **CENTRE NATIONAL DE LA RECHERCHE SCIENTIFIQUE**
**15, quai Anatole France**
**F-75007 Paris(FR)**

(72) Inventeur: **Armas, Bénigno**
**Maison Solaire II Odeillo**
**F-66120 Font Romeu(FR)**
Inventeur: **Bes René**
**28 avenue des Sources**
**F-31320 Castanet Tolosan(FR)**
Inventeur: **Combescure, Christian**
**Rue des Casteillets**
**F-66340 Osseja(FR)**
Inventeur: **Dartigues, Guy**
**1206 Chemin de Lagardelle**
**F-31120 Labarthe/Leze(FR)**
Inventeur: **Thenegal, Daniel**
**Le Prat de l'Hort**
**F-66210 Mont-Louis(FR)**

(74) Mandataire: **Barre, Philippe**
**Cabinet Barre-Gatti-Laforgue 95 rue des Amidonniers**
**F-31069 Toulouse Cédex(FR)**

(54) **Procédé et dispositif de dépôt chimique en phase gazeuse avec activations électronique et thermique.**

(57) L'invention concerne un procédé et un dispositif de dépôt chimique sur un substrat à partir d'au moins une phase gazeuse contenant les éléments à déposer. Le procédé consiste à faire circuler la phase gazeuse successivement dans deux zones distinctes : une première zone d'activation électronique ($Z_e$) dans laquelle au moins une fraction de la phase gazeuse est soumise à un champ électronique alternatif pour assurer la formation d'un plasma froid, une seconde zone d'activation thermique ($Z_t$) dans laquelle est placé un substrat (S) qui est chauffé à une température adaptée pour assurer le dépôt. Les deux zones sont découplées sur le plan thermique et sur le plan électrique. Le procédé de l'invention, qui conduit donc à opérer les deux modes d'activation de façon distincte sans interaction sensible l'un sur l'autre, permet de réduire très notablement les températures de mise en oeuvre dans la zone d'activation thermique et de travailler dans une plage de pression très étendue.

Fig. 1

## PROCEDE ET DISPOSITIF DE DEPOT CHIMIQUE EN PHASE GAZEUSE AVEC ACTIVATIONS ELECTRONI-QUE ET THERMIQUE

L'invention concerne un procédé de dépôt chimique en phase gazeuse du type dans lequel la phase gazeuse est soumise à une double activation électronique et thermique. Elle s'étend à un dispositif de mise en oeuvre dudit procédé.

On sait que les procédés de dépôt chimique à partir d'une phase gazeuse (C.V.D. : "Chemical Vapour Deposition") consistent à amener au contact d'un substrat une phase gazeuse contenant les éléments à déposer et à chauffer le substrat (activation thermique) en vue d'apporter l'énergie nécessaire à la réaction chimique de dépôt. Pour réduire les températures d'activation thermique nécessaires, certains procédés réalisent simultanément une activation électronique assurant la formation d'un plasma dans la zone d'activation thermique (P.E.C.V.D. : "Plasma Enhanced Chemical Vapour Deposition"). A cet effet, les dispositifs connus "P.E.C.V.D." comprennent autour de la chambre de dépôt contenant le substrat des moyens de génération de plasma radiofréquence ou micro-onde. Toutefois, on constate que l'abaissement de température autorisé par l'activation électronique est relativement modéré, généralement de l'ordre de 100° C ; en particulier, malgré cette activation électronique, de nombreux dépôts nécessitant des températures élevées ne peuvent pas être effectués sur certains substrats qui sont inaptes à supporter ces températures : par exemple, un dépôt de nitrure de silicium ne peut être effectué sur les aciers courants, car, quelles que soient les puissances mises en oeuvre pour réaliser l'activation électronique, la température nécessaire au dépôt demeure de même ordre que les températures de changement d'état physique de ces matériaux (exemple pour un dépôt de nitrure de silicium de tétraméthylsilane et d'ammoniac : température de dépôt en l'absence d'activation électronique : 1 000° C environ ; température avec activation électronique : 900 °C ; température de changement d'état de l'acier du même ordre). Par ailleurs, les pressions de gaz dans le procédé P.E.C.V.D. connu sont nécessairement très basses (généralement de l'ordre de 20 Pascal), de sorte que les quantités déposées par unité de temps sont faibles ; au surplus, certaines espèces très volatiles ne peuvent pas être déposées (la tension de vapeur de l'espèce doit être inférieure à la pression de fonctionnement, ce qui n'est pas possible avec des espèces très volatiles). Par exemple, le brevet JP-A-61 179868 (CANON INC.) qui est résumé dans le "Patent Abstracts of Japan", vol. 11 n° 3, C-395, 2450, 7/1/87 paraît décrire un procédé du type ci-dessus évoqué.

Par ailleurs, certains procédés (qui ne sont pas des procédés P.E.C.V.D. du type évoqué ci-dessus) consistent à réaliser uniquement une activation électronique de la phase gazeuse au moyen d'une torche à plasma haute fréquence qui conduit à un plasma thermique (plasma d'arc) dont on sait que la température est très élevée (très supérieure à 1 500° C, atteignant des valeurs de 6 000 à 7 000° C). Toutefois, ce type d'activation électronique conduit à un mauvais accrochage du dépôt sur le substrat, car le dépôt se trouve collé en surface du substrat en l'absence de diffusion à l'intérieur de celui-ci ; pour améliorer l'accrochage, certains prévoient un rechauffage du substrat généralement aux alentours de 200° C, mais sans supprimer réellement le défaut sus-évoqué (brevet JP-A-61 41763 ANELVA CORP. évoqué dans le "Patent Abstracts of Japan", vol. 10 n° 199, C-359, 2255, 11/07/86).

La présente invention se propose d'améliorer le procédé P.E.C.V.D. évoqué précédemment en vue d'en limiter les défauts précités. Elle vise en particulier à abaisser notablement les températures d'activation thermique nécessaires (abaissement de température au moins égal à l'abaissement que permet le procédé P.E.C.V.D. connu par rapport au procédé C.V.D. sans activation électronique).

Un autre objectif de l'invention est d'autoriser la réalisation de dépôt à des pressions très supérieures à celles du procédé P.E.C.V.D. connu, en particulier pression atmosphérique ou même surpression afin d'augmenter les quantités déposées par unité de temps.

Un autre objectif est de faciliter la réalisation de dépôts à partir de plusieurs phases gazeuses contenant des éléments différents à déposer, en permettant d'assurer une activation électronique optimale pour chaque phase gazeuse.

Un autre objectif est d'obtenir des dépôts bénéficiant d'un excellent accrochage sur le substrat grâce à une diffusion à l'intérieur de celui-ci.

A cet effet, le procédé de dépôt chimique visé par l'invention, du type P.E.C.V.D. dans lequel au moins une phase gazeuse est soumise à une activation électronique et à une activation thermique, se caractérise en ce que :
- chaque phase gazeuse est amenée à circuler successivement dans deux zones distinctes : une première zone dite d'activation électronique, et une seconde zone dite d'activation thermique dans laquelle est placé le substrat,
- l'activation électronique est d'abord réalisée dans la première zone en soumettant au moins une fraction de la phase gazeuse à un champ électrique alternatif de basse ou moyenne fréquence inférieure à environ 10 kilohertz, de façon à assurer la formation d'un plasma froid au sein de ladite phase gazeuse,

- la zone d'activation électronique est soumise à une régulation thermique de façon à la maintenir à une température inférieure à 250° C,

- l'activation thermique est ensuite réalisée dans la seconde zone située au voisinage de la première zone à l'extérieur de la zone d'influence du champ électrique, en chauffant le substrat à une température adaptée pour assurer le dépôt, sans réchauffement sensible de la première zone.

Ainsi, le procédé P.E.C.V.D. de l'invention conduit à réaliser l'activation électronique et l'activation thermique dans les conditions suivantes :

    a) séparation totale de l'activation électronique et de l'activation thermique qui sont mises en oeuvre non plus simultanément dans une même zone du réacteur, mais de façon étagée et ordonnée (d'abord l'activation électronique, puis l'activation thermique) dans deux zones distinctes sans interaction sensible des deux modes d'activation l'un sur l'autre.

    b) réalisation d'une activation électronique par plasma froid grâce à un champ basse ou moyenne fréquence, afin de produire de façon extrêmement efficace des espèces métastables neutres, exigeant ensuite dans la zone d'activation thermique un niveau thermique beaucoup plus faible que dans les procédés P.E.C.V.D. classiques pour engendrer le dépôt sur le substrat,

    c) régulation thermique de la zone d'activation électronique pour limiter la température dans cette zone et ne pas détruire les espèces métastables neutres produites.

Les expérimentations ont montré que cette façon de procéder permettait de réduire très notablement les températures d'activation thermique (500° C à 700° C) et de travailler dans une plage de pression très étendue ; les températures d'activation thermique ainsi réduites par rapport au procédé P.E.C.V.D. connu permettent d'effectuer certains dépôts jusqu'ici irréalisables par ce type de procédé, cependant que la pression de fonctionnement pourra être optimisée dans chaque application en fonction de la productivité désirée ; en pratique, la pression de fonctionnement sera ajustée dans une plage comprise entre $2.10^2$ et $2.10^5$ Pascal (pression absolue). De plus, malgré ces températures plus modérées, on obtient une bonne diffusuion du dépôt à la surface du substrat et un excellent accrochage, de qualité au moins équivalente à celle des procédés P.E.C.V.D. connus (la qualité de cet accrochage étant sans comparaison avec celui des procédés utilisant une activation électronique par plasma thermique). Ces effets inattendus sont actuellement difficilement interprétables et une amorce d'explication peut être la suivante : l'activation électronique réalisée par plasma froid sans augmentation notable de température modifie l'énergie interne des molécules contenant les éléments à déposer pour donner des espèces métastables neutres, dont l'obtention exige moins d'énergie de sorte que leur densité est plus élevée à niveau énergétique d'activation égal ; cette production d'espèces métastables est défavorisée par les températures élevées, de sorte que dans les procédés P.E.C.V.D. classiques, l'activation électronique possède une efficacité médiocre (il est à noter en outre que, dans ces procédés, P.E.C.V.D. classiques, on utilise généralement un champ radiofréquence (fréquence de l'ordre de la dizaine de mégahertz) ou un champ micro-onde (fréquence de l'ordre du Gigahertz) qui favorise la production des espèces ionisées). Au contraire dans l'invention, la production à basse température des espèces métastables neutres par le champ basse ou moyenne fréquence s'opère dans des conditions optimales et il suffit ensuite d'un niveau thermique beaucoup plus faible pour effectuer le dépôt en raison de la densité plus élevée d'espèces métastables qui ont été produites dans la zone d'activation électronique et qui arrivent au contact du substrat. (Il est à noter que, dans les procédés à plasma thermique, les espèces engendrées sont uniquement des espèces ionisées).

Il semble que la température de 250° C soit une limite à ne pas dépasser dans la zone d'activation électronique pour permettre une production efficace majoritaire des espèces métastables neutres précitées.

L'activation électronique peut être effectuée dans la zone d'activation sur la totalité de la phase gazeuse circulant dans cette zone ou sur une fraction de celle-ci. Cette dernière disposition sera préférée en pratique, car elle limite l'échauffement de la phase gazeuse dû à l'énergie électrique, sans réduire notablement l'efficacité de l'activation. Le mode de mise en oeuvre de l'activation électronique consiste alors :

- à disposer, d'une part, au sein du flux gazeux, une électrode haute tension grillagée cylindrique dont le maillage est avantageusement carré de côté au moins égal à la longueur de DEBYE, d'autre part, autour du flux, une paroi diélectrique délimitant un espace annulaire avec l'électrode haute tension, enfin, autour de ladite paroi diélectrique, une électrode reliée à la masse, définissant une faible distance interélectrode, de préférence au plus égale à 3 mm (distance séparant la face périphérique de l'électrode haute tension et la face interne de l'électrode de masse),

- et à porter l'électrode haute tension à un potentiel alternatif par rapport à la masse, de valeur efficace inférieure à la tension de claquage de la phase gazeuse.

Ce type d'activation privilégie l'obtention d'espèces métastables neutres à faible niveau énergétique, et améliore leur diffusion hors du plasma à travers l'électrode grillagée, en vue de leur transfert dans les meilleures conditions vers la zone d'activation thermique.

L'électrode de masse est avantageusement constituée par un liquide électriquement conducteur relié à la masse : elle peut ainsi remplir la fonction de régulation thermique de la zone d'activation électronique.

Le procédé de l'invention peut être mis en oeuvre pour effectuer un dépôt à partir de plusieurs phases gazeuses dans les conditions suivantes :

- l'activation électronique est réalisée indépendamment sur chaque phase gazeuse, dans plusieurs premières zones séparées dans lesquelles sont amenées à circuler en parallèle lesdites phases gazeuses,

- après activation électronique, les phases gazeuses sont mélangées en amont ou au niveau de la zone d'activation thermique.

Les conditions de mise en oeuvre de chaque activation électronique (fréquence, densité de puissance, température de régulation, distance interélectrode) sont ainsi optimisables indépendamment pour chaque phase gazeuse afin de produire les espèces métastables appropriées avec une densité optimale.

L'invention s'étend à un dispositif de dépôt chimique adapté à la mise en oeuvre du procédé précité. Ce dispositif est du type comprenant un réacteur équipé de moyens d'admission d'au moins une phase gazeuse et de moyens de pompage en vue d'assurer une circulation de la phase gazeuse dans le réacteur, des moyens de génération d'un plasma froid, des moyens pour maintenir le substrat dans le réacteur et des moyens de chauffage dudit substrat ; selon l'invention, ledit dispositif se caractérise en ce que :

- le réacteur comprend au moins deux zones distinctes : au moins une zone dite d'activation électronique située en amont par rapport au sens de circulation de la phase gazeuse, et une autre zone dite d'activation thermique située en aval,

- les moyens de génération de plasma sont associés à chaque zone d'activation électronique de façon à engendrer un champ électrique de basse ou moyenne fréquence inférieure à enrivon 10 kilohertz localisé dans ladite zone d'activation électronique sans interaction sensible sur la zone d'activation thermique,

- des moyens de régulation thermique sont associés à chaque zone d'activation électronique en vue de permettre de maintenir celle-ci à une température inférieure à 250° C,

- les moyens de chauffage sont disposés en regard de la zone d'activation thermique, sans interaction thermique sensible sur la ou les zones d'activation électronique,

- les moyens pour maintenir le substrat sont adaptés pour positionner ledit substrat dans la zone d'activation thermique.

L'invention ayant été exposée dans sa forme générale, d'autres caractéristiques, buts et avantages ressortiront de la description qui suit en référence aux dessins annexés qui en présentent à titre d'exemples non limitatifs deux modes de réalisation ; sur ces dessins qui font partie intégrante de la présente description :

- la figure 1 est une vue schématique d'un premier mode de réalisation à zone d'activation électronique unique,

- la figure 2 est une vue en coupe longitudinale axiale du réacteur de ce dispositif,

- la figure 3 en est une coupe transversale par un plan A,

- la figure 4 est une vue schématique d'un second mode de réalisation à plusieurs zones d'activation électronique.

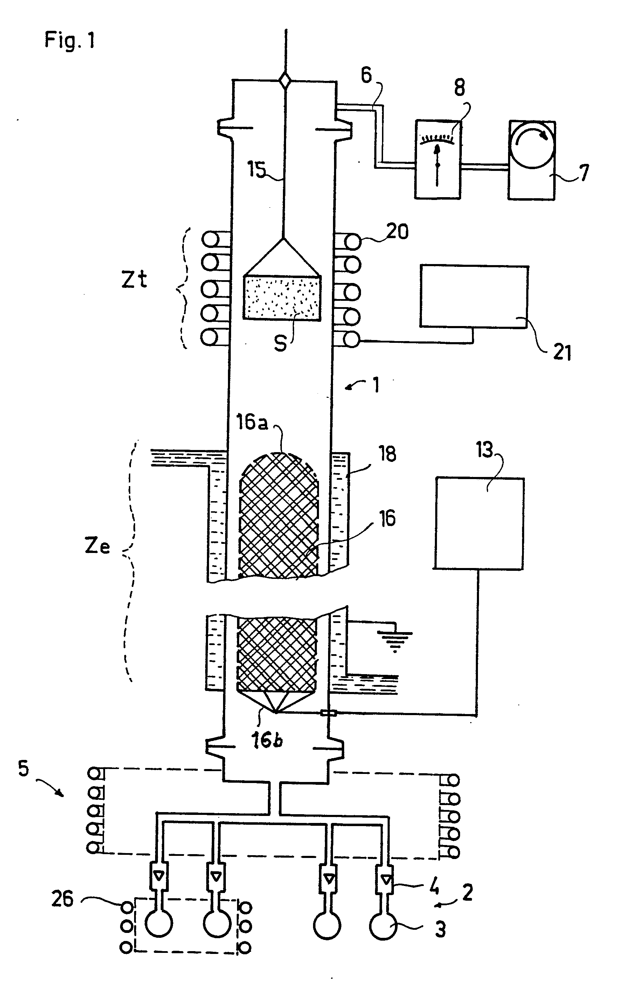

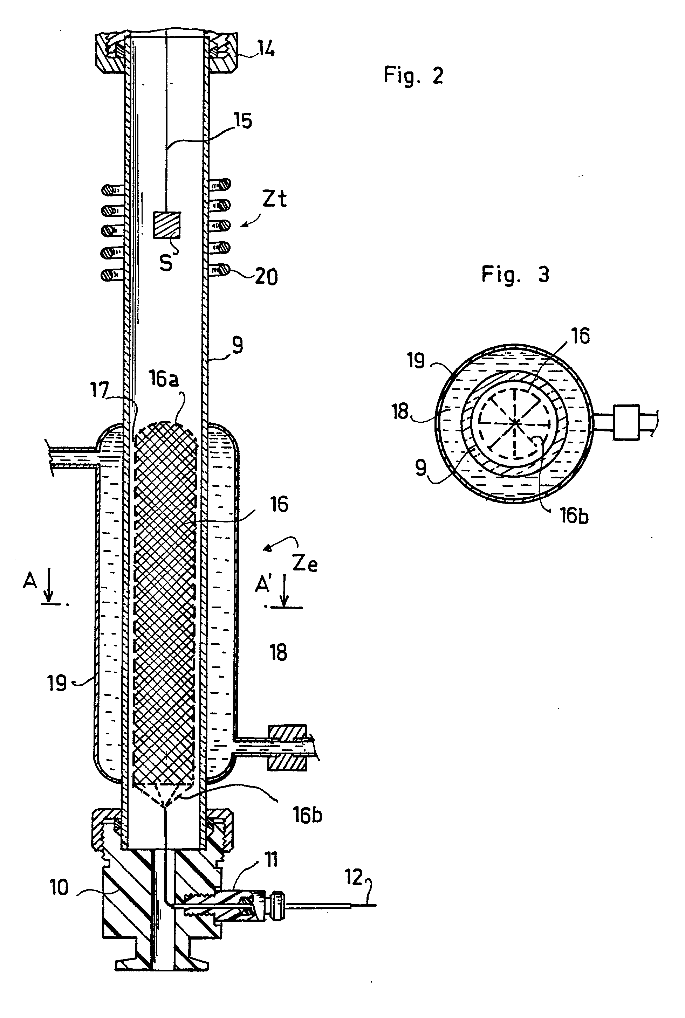

Le dispositif représenté à titre d'exemple aux figures 1, 2 et 3 est destiné à la réalisation de dépôts chimiques en phase gazeuse sur un substrat (symbolisé en S aux figures 1 et 2). Par "substrat", on entend tout type de corps dont la surface est à revêtir, d'un seul tenant ou formé d'une pluralité d'éléments.

Le dispositif comprend un réacteur 1 qui est présenté en coupe axiale à la figure 2. Ce réacteur est couplé en partie basse à des moyens d'admission d'une phase gazeuse, schématisés en 2 à la figure 1.

En l'exemple, ces moyens d'admission comprennent plusieurs enceintes de stockage telles que 3 contenant les gaz et/ou vapeurs renfermant les éléments chimiques réactifs nécessaires au dépôt. A la figure 1, on a représenté, associés à deux enceintes de stockage, des moyens de chauffage 26 de type classique qui permettent l'obtention de vapeurs à partir de composés solides ou liquides. Après passage dans des moyens de régulation de débit 4, ces gaz et/ou vapeur sont mélangés et préchauffés pour engendrer la phase gazeuse qui sera admise dans le réacteur 1 pour réaliser le dépôt.

Des moyens de préchauffage tel qu'un système d'étuvage 5 sont disposés en amont de l'entrée dans le réacteur pour porter la phase gazeuse à une température régulée prédéterminée inférieure à 250° C, en pratique de l'ordre de 80° C (température de régulation de la zone d'activation électronique du réacteur).

A sa partie supérieure, le réacteur 1 est relié à une tubulure de sortie 6 qui est branchée sur des moyens de pompage tels que groupe de vide 7 par l'entremise d'un régulateur de pression 8. Ce régulateur 8 combiné aux moyens de régulation de débit 4 permet dans chaque application de faire circuler la phase gazeuse dans le réacteur et d'ajuster sa pression et son débit aux valeurs désirées. Le procédé de l'invention permet de travailler à des pressions beaucoup plus élevées que le procédé P.E.C.V.D. traditionnel et en pratique la pression dans le réacteur pourra être ajustée dans une plage comprise entre $2.10^2$ et $2.10^5$ Pascal.

Le réacteur 1 comprend une paroi tubulaire 9 en un matériau diélectrique de haute résistance thermique, en particulier en quartz. A sa base cette paroi 9 est équipée d'un embout 10 en un matériau isolant électrique et thermique (notamment polytétrafluoroéthylène) qui est adapté pour être relié de façon étanche avec les moyens d'admission de la phase gazeuse ; cet embout porte une tête 11 d'alimentation électrique vissée sur celui-ci ; ladite tête est dotée d'un conducteur central 12 qui est électriquement relié à des moyens d'alimentation électrique (symbolisés en 13 à la figure 1). Ces moyens de type classique en eux-mêmes sont adaptés pour appliquer un potentiel alternatif de basse ou moyenne fréquence inférieure à 10 kilohertz, dont la tension de crête peut atteindre 20 kVolt.

A sa partie haute, la paroi tubulaire 9 est équipée d'un raccord 14 qui assure la liaison étanche avec la tubulure de sortie 6 et permet d'accrocher un fil 15 de suspension du substrat S, fil indéformable en molybdène.

Sur la hauteur de sa paroi tubulaire, le réacteur comprend deux zones distinctes, ayant des rôles différents : une zone d'activation électronique $Z_e$ et une zone d'activation thermique $Z_t$.

La zone d'activation électronique est située en partie basse du côté de l'entrée du réacteur de façon que la phase gazeuse subisse d'abord cette activation, avant de circuler vers la zone supérieure d'activation thermique située du côté de la sortie du réacteur. Le substrat S est suspendu au coeur de la zone d'activation thermique $Z_t$.

La zone d'activation électronique $Z_e$ comprend une électrode haute tension 15 qui se présente sous la forme d'un tube cylindrique en grillage en acier inoxydable à mailles carrées. Cette électrode cylindrique se prolonge en partie haute par un dôme conducteur 16a, lui même grillagé, adapté pour refermer les lignes de champ électrique. En partie basse l'électrode est reliée au conducteur 12 d'alimentation par un faisceau de conducteurs en parapluie 16b.

Le côté de la maille de l'électrode 15 est choisi à une valeur supérieure à la longueur de DEBYE qui est de l'ordre de 50 à 60 $\mu$m pour les plasmas visés aux exemples ; on a choisi dans ces exemples une maille de 116 $\mu$m. Cette condition contribue à la formation d'un plasma macroscopiquement neutre, donnant des espèces métastables aptes à diffuser de l'espace annulaire interélectrode où elles se forment vers l'intérieur de l'électrode grillagée 16.

Cette électrode grillagée est maintenue sur sa hauteur par des entretoises diélectriques telles que 17 qui sont agencées autour de celle-ci.

L'électrode de masse est constituée par un liquide électriquement conducteur 18 (par exemple : huile conductrice à haute constante diélectrique) qui circule dans une chemise 19. Ce liquide est électroniquement relié à la masse et s'étend sur toute la hauteur de la zone d'activation électronique $Z_e$ (c'est-à-dire de l'électrode haute tension 16). Une boucle (non représentée) dotée de moyens de circulation et de refroidissement est associée à la chemise 19 de sorte que le liquide soit apte à assurer une régulation thermique de la zone d'activation électronique, maintenant celle-ci à une température inférieure à 250° C, de l'ordre de 30 à 90° C dans les exemples de mise en oeuvre qui suivent.

La distance interélectrode séparant l'électrode haute tension 16 et l'électrode liquide 18 (égale à la somme de l'épaisseur de gaz entre électrode haute tension et paroi diélectrique, et de l'épaisseur de la paroi diélectrique) est prévue au plus égale à 3 mm et de l'ordre de 2,7 mm dans les exemples de mises en oeuvre. La paroi diélectrique 9 ayant une épaisseur d'environ 2 mm, la distance entre l'électrode haute tension (face périphérique) et la paroi diélectrique (face interne) est de 0,7 mm.

L'électrode haute tension est portée par les moyens d'alimentation 13 à un potentiel alternatif par rapport à l'électrode de masse, supérieur à la tension de claquage de la phase gazeuse.

La combinaison des caractéristiques définies ci-dessus, et notamment : la température réduite de la phase gazeuse, la pression élevée, le faible espace interélectrodes et la structure du maillage de l'électrode haute tension contribue à assurer entre électrodes la formation d'un plasma froid, engendrant une densité élevée d'espèces métastables neutres qui diffusent à travers la grille dans toute la section du réacteur et sont entraînées dans la zone d'activation thermique. Il est à noter que le fait de ne soumettre au champ d'activation qu'une fraction de la phase gazeuse permet une dissipation de la chaleur produite par effet Joule, évitant tout échauffement local. L'activation électronique peut ainsi s'opérer à froid dans les meilleures conditions.

Par ailleurs, la zone d'activation thermique $Z_t$ qui est décalée vers le haut du réacteur de façon à être découplée de la zone d'activation électronique

$Z_e$ aussi bien sur le plan thermique que sur le plan électrique, comporte une bobine d'induction HF 20 agencée autour de la paroi tubulaire 9 en vue de chauffer le substrat par induction. Cette bobine est électriquement reliée à des moyens d'alimentation électrique 21 de type classique, qui assurent une régulation de la température. La température du substrat sera ainsi ajustée en fonction de chaque application à la valeur appropriée qui peut être très inférieure à celle requise dans le procédé P.E.C.V.D. connu, en raison de la forte densité d'espèces métastables neutres qui parviennent dans la zone d'activation thermique.

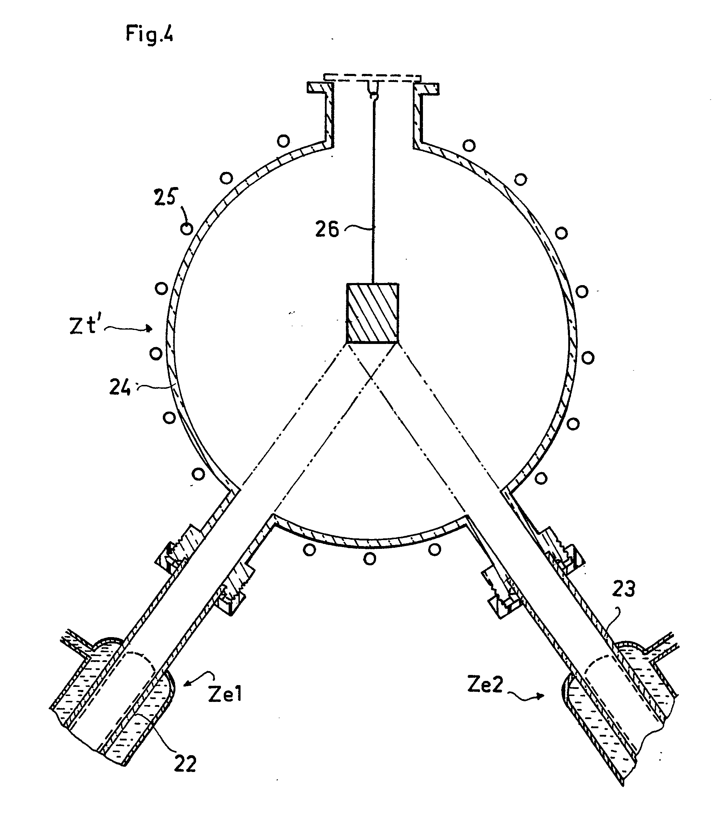

La figure 4 présente, en variante, un dispositif possédant plusieurs zones d'activation électronique (en l'exemple deux : $Z_{e1}$, $Z_{e2}$) situées dans des enceintes tubulaires différentes 22, 23, lesquelles sont chacune équipées d'un générateur de plasma froid analogue à celui déjà décrit. Chacune de ces enceintes est alimentée en une phase gazeuse et les conditions d'activation (distance interélectrode, potentiel et fréquence, température) peuvent être optimisées indépendamment pour chaque phase gazeuse afin d'obtenir dans les meilleures conditions les espèces métastables favorisant le dépôt. Ces enceintes sont raccordées à une enceinte 24 (en l'exemple sphérique) qui forme une chambre d'activation thermique $Z'_t$ où les phases gazeuses viennent se mélanger au voisinage du substrat.

En l'exemple, la bobine 25 d'induction est disposée à l'extérieur de l'enceinte 24 comme sur la figure 1. Il est à noter que le nombre de zones d'activations électroniques peut être différent de deux et est fonction du nombre d'espèces moléculaires contenues dans la phase gazeuse, nécessaires au dépôt du composé chimique désiré sur le substrat solide, lequel est disposé dans la zone unique d'activation thermique.

Les exemples qui suivent ont été mis en oeuvre dans un dispositif du type de celui des figures 1, 2 et 3, la fréquence du champ d'activation électronique étant de 600 Hertz et la distance interélectrode de 2,72 mm (épaisseur du diélectrique : 2 mm ; épaisseur de l'intervalle de gaz : 0,72 mm).

## EXEMPLE 1 : DEPOT DE NITRURE DE SILICIUM

Cet exemple vise l'obtention de dépôt de nitrure de silicium $Si_3N_4$. La phase gazeuse utilisée est un mélange de tétraméthylsilane TMS, d'ammoniac $NH_3$ et d'hydrogène $H_2$, les débits respectifs de ces composés étant de 15 cm$^3$/mn, 45 cm$^3$/mn et 100 cm$^3$/mn. La pression est ajustée à 4.10$^4$ Pascal.

Les dépôts obtenus sont caractérisés par diffraction de rayons X, microscopie électronique à balayage et spectroscopie Auger.

A cet exemple, le substrat est en graphite et sa température est ajustée à 810° C.

Les conditions d'activation électronique sont les suivantes :
- température : 20° C,
- tension de crête : 8 kVolt.

L'on obtient un dépôt de $Si_3N_4$ adhérant sur le graphite, de morphologie colonnaire et dont l'épaisseur atteint environ 4 $\mu$m par heure.

## EXEMPLE 2 : DEPOT SUR CARBURE DE SILICIUM

Les conditions expérimentales sont similaires à celles de l'exemple 1 avec un substrat en carbure de silicium.

Conditions d'activation électronique :
- température : 20° C,
- tension de crête : 8 kVolt.

Dépôt de $Si_3N_4$ uniforme et adhérent, dont l'épaisseur atteint environ 2 $\mu$m/h.

## EXEMPLE 3 : DEPOTS SUR SUBSTRATS METALLIQUES

Les conditions expérimentales sont similaires à celles de l'exemple 1 avec des substrats en fer pur, en acier inoxydable et en molybdène, portés à des températures qui ont été amenées à varier entre 780° C et 810° C.

Conditions d'activation électronique :
- température : 18° C,
- tension de crête : 7.5 kVolt.

Les dépôts obtenus sont dans tous les cas de $Si_3N_4$, uniforme et adhérent, d'une épaisseur voisine de 1 $\mu$m/h.

## EXEMPLE 4 : NITRURATION DE SUBSTRATS EN TITANE

La phase gazeuse est un mélange de $NH_3$ - (débit : 45 cm$^3$/mn) et de $H_2$ (débit : 100 cm$^3$/mn). La pression est ajustée à 3,7.10$^4$ Pascal.

Ce substrat en titane est porté à 750° C.

Conditions d'activation électronique :
- température : 22° C,
- tension de crête : 8 kVolt.

On obtient un dépôt de TiN parfaitement uniforme, à la vitesse de 0,6 mg/h environ.

## EXEMPLE 5 : DEPOT DE NITRURE DE SILICIUM SUR TITANE

Sur le substrat recouvert du dépôt obtenu à l'exemple 4, on effectue un dépôt de $Si_3N_4$ dans des conditions expérimentales similaires à celles de l'exemple 1.

La composition gazeuse est la suivante : tétra-méthylsilane (15 $cm^3$/mn), ammoniac (45 $cm^3$/mn), hydrogène (100 $cm^3$/mn).

Conditions d'activation électronique :
- température : 17° C,
- tension de crête : 8 kVolt.

Le dépôt de $Si_3N_4$ adhère parfaitement sur le dépôt de TiN et son épaisseur est d'environ 1,5 $\mu$m/h.

**Revendications**

1/ - Procédé de dépôt chimique sur un substrat à partir d'au moins une phase gazeuse contenant les éléments à déposer, du type dans lequel chaque phase gazeuse est soumise à une activation électronique et à une activation thermique, ledit procédé étant caractérisé en ce que :
- chaque phase gazeuse est amenée à circuler successivement dans deux zones distinctes : une première zone dite d'activation électronique ($Z_e$), et une seconde zone dite d'activation thermique ($Z_t$) dans laquelle est placé le substrat (S),
- l'activation électronique est d'abord réalisée dans la première zone ($Z_e$) en soumettant au moins une fraction de la phase gazeuse à un champ électrique alternatif de basse ou moyenne fréquence inférieure à environ 10 kilohertz, de façon à assurer la formation d'un plasma froid au sein de ladite phase gazeuse,
- la zone d'activation électronique ($Z_e$) est soumise à une régulation thermique de façon à la maintenir à une température inférieure à 250° C,
- l'activation thermique est ensuite réalisée dans la seconde zone ($Z_t$) située au voisinage de la première zone à l'extérieur de la zone d'influence du champ électrique, en chauffant le substrat à une température adaptée pour assurer le dépôt, sans réchauffement sensible de la première zone.

2/ - Procédé selon la revendication 1, caractérisé en ce que l'activation électronique est réalisée sur une fraction de la phase gazeuse :
- en disposant, d'une part, au sein du flux gazeux, une électrode haute tension grillagée cylindrique (16), d'autre part, autour du flux, une paroi diélectrique (9) délimitant un espace annulaire avec l'électrode haute tension, enfin, autour de ladite paroi diélectrique, une électrode cylindrique (18) reliée à la masse,
- et en portant l'électrode haute tension à un potentiel alternatif par rapport à la masse, de valeur efficace inférieure à la tension du claquage de la phase gazeuse.

3/ - Procédé selon la revendication 2, caractérisé en ce que l'on agence l'électrode haute tension (16) et l'électrode de masse (18) de sorte que la distance interélectrodes soit au plus égale à 3 mm.

4/ - Procédé selon l'une des revendications 2 ou 3, caractérisé en ce que l'on choisit une électrode haute tension (16) à maillage carré, de côté au moins égal à la longueur de DEBYE.

5/ - Procédé selon la revendication 2, caractérisé en ce que la régulation thermique dans la zone d'activation électronique ($Z_e$) est réalisée en faisant circuler autour de la paroi diélectrique (9) un liquide électriquement conducteur (18), ledit liquide étant relié à la masse pour faire office d'électrode de masse.

6/ - Procédé selon l'une des revendications 1, 2, 3, 4 ou 5, dans lequel l'activation thermique est réalisée dans la seconde zone ($Z_t$) en chauffant le substrat par induction.

7/ - Procédé selon l'une des revendications précédentes, dans lequel la phase gazeuse est amenée à circuler dans les zones d'activation électronique ($Z_e$) et thermique ($Z_t$) à une presson absolue comprise entre $2.10^2$ et $2.10^5$ Pascal.

8/ - Procédé selon l'une des revendications précédentes pour réaliser un dépôt à partir de plusieurs phases gazeuses, caractérisé en ce que :
- l'activation électronique est réalisée indépendamment sur chaque phase gazeuse dans plusieurs zones d'activation électronique ($Z_e$) séparées, dans lesquelles sont amenées à circuler en parallèle lesdites phases gazeuses,
- après activation électronique, les phases gazeuses sont mélangées en amont ou au niveau de la zone d'activation thermique ($Z_t$).

9/ - Dispositif de dépôt chimique en phase gazeuse, en vue de la mise en oeuvre du procédé conforme à l'une des revendications précédentes, comprenant un réacteur (1) équipé de moyens d'admission (2) d'au moins une phase gazeuse et de moyens (7, 8) de pompage en vue d'assurer une circulation de ladite phase gazeuse dans le réacteur, des moyens de génération d'un plasma froid (13, 16-18), des moyens (15) pour maintenir le substrat dans le réacteur et des moyens (20) de chauffage dudit substrat, ledit dispositif étant caractérisé en ce que :
- le réacteur comprend au moins deux zones distinctes : au moins une zone dite d'activation électronique ($Z_e$) située en amont par rapport au sens de circulation de la phase gazeuse, et une autre zone dite d'activation thermique ($Z_t$) située en aval,
- les moyens de génération de plasma (13, 16-18) sont associés à chaque zone d'activation électronique ($Z_e$), de façon à engendrer un champ électrique de basse ou moyenne fréquence inférieure à environ 10 kilohertz localisé dans ladite zone d'activation électronique sans interaction sensible sur la zone d'activation thermique,

- des moyens de régulation thermique sont associés à chaque zone d'activation électronique en vue de permettre de maintenir celle-ci à une température inférieure à 250° C,

- les moyens de chauffage (20) sont disposés en regard de la zone d'activation thermique ($Z_t$), sans interaction thermique sensible sur la ou les zones d'activation électronique,

- les moyens (15) pour maintenir le substrat sont adaptés pour positionner ledit substrat dans la zone d'activation thermique ($Z_t$).

10/ - Dispositif selon la revendication 9, caractérisé en ce que les moyens de génération de plasma associés à chaque zone d'activation électronique ($Z_e$) comprennent une électrode haute tension grillagée de forme cylindrique (16) située dans la zone d'activation électronique, une paroi diélectrique (9) disposée autour de l'électrode haute tension pour délimiter avec celle-ci un espace annulaire, une électrode de masse (18) entourant la paroi diélectrique, et des moyens (13) d'application entre l'électrode haute tension et l'électrode de masse d'un potentiel alternatif de basse ou moyenne fréquence inférieure à environ 10 kilohertz.

11/ - Dispositif selon la revendication 10, caractérisé en ce que l'électrode haute tension (16) et l'électrode de masse (18) sont situées à une distance l'une de l'autre au plus égale à 3 mm.

12/ - Dispositif selon l'une des revendications 10 ou 11, caractérisé en ce que l'électrode haute tension (16) comprend un maillage carré, de côté au moins égal à la longueur de DEBYE.

13/ - Dispositif selon l'une des revendications 10, 11 ou 12, caractérisé en ce que l'électrode haute tension (16) est prolongée sur ses bords cylindriques extrêmes de moyens conducteurs (16a, 16b) adaptés pour refermer les lignes de champ électrique.

14/ - Dispositif selon l'une des revendications 10, 11, 12 ou 13, caractérisé en ce que l'électrode de masse comprend une chemise (19) remplie d'un liquid électriquement conducteur (18) entourant la paroi diélectrique (9), des moyens de circulation et de refroidissement dudit liquide et des moyens de liaison électrique de celui-ci à la masse.

15/ - Dispositif selon l'une des revendications 9 à 14, dans lequel les moyens de chauffage du substrat comprennent des moyens d'induction haute fréquence (20) situés autour de la paroi (9) du réacteur au niveau de la zone d'activation thermique ($Z_t$), ladite paroi étant réalisée en un matériau diélectrique de haute résistance thermique tel que quartz.

16/ - Dispositif selon l'une des revendications 9 à 15, dans lequel des moyens de préchauffage (5) sont disposés en amont de la ou des zones d'activation électronique ($Z_e$).

17/ - Dispositif selon l'une des revendications 9 à 16, dans lequel des moyens de régulation du débit (4) et des moyens de régulation de pression (8) sont associés aux moyens d'admission des phases gazeuses et aux moyens de pompage.

18/ - Dispositif selon l'une des revendications 9 à 17, comprenant une zone d'activation électronique unique ($Z_e$) située en ligne avec la zone d'activation thermique ($Z_t$) dans un réacteur cylindrique.

19/ - Dispositif selon l'une des revendications 9 à 17, comprenant plusieurs zones d'activation électronique ($Z_{e1}$, $Z_{e2}$) situées dans plusieurs enceintes équipées chacune d'un générateur de plasma froid, lesdites enceintes débouchant dans une chambre (24) du réacteur formant la zone d'activation thermique ($Z'_t$).

Fig. 1

Fig. 2

Fig. 3

Fig.4

Office européen
des brevets

RAPPORT DE RECHERCHE EUROPEENNE

Numero de la demande

EP  89 20 3219

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A,D | PATENT ABSTRACTS OF JAPAN, vol. 11, no. 3 (C-395)[2450], 7 janvier 1987; & JP-A-61 179 868 (CANON INC.) 12-08-1986 * En entier * --- | 1,8,9 | C 23 C  16/44<br>C 23 C  16/50 |
| A,D | PATENT ABSTRACTS OF JAPAN, vol. 10, no. 199 (C-359)[2255], 11 juillet 1986; & JP-A-61 41 763 (ANELVA CORP.) 28-02-1986 * En entier * --- | 1,9 | |
| A | US-A-4 634 601  (HAMAKAWA et al.) * Colonne 3, lignes 15-21 * --- | 1,10 | |
| A | DE-A-3 102 174  (MITSUBISHI DENKI) * Figure 3 * --- | 2,10 | |
| A | FR-A-1 173 828  (SAINT-GOBAIN, CHAUNY & CIREY) * Figure 2; page 2, colonne de droite, paragraphe 2 * ----- | 5,14 | |

DOMAINES TECHNIQUES RECHERCHES (Int. Cl.5)

C 23 C
H 01 J

Le présent rapport a été établi pour toutes les revendications

| Lieu de la recherche | Date d'achèvement de la recherche | Examinateur |
|---|---|---|
| LA HAYE | 29-03-1990 | PATTERSON A.M. |